Europäisches Patentamt

European Patent Office

Office européen des brevets

(11) Numéro de publication: **0 270 402 B1**

## (12) FASCICULE DE BREVET EUROPEEN

(45) Date de publication de fascicule du brevet: **30.12.92**  (51) Int. Cl.⁵: **G06F  9/32**, G11C 8/00

(21) Numéro de dépôt: **87402421.9**

(22) Date de dépôt: **27.10.87**

(54) **Séquenceur d'accès direct mémoire.**

(30) Priorité: **31.10.86 FR 8615240**

(43) Date de publication de la demande:
**08.06.88 Bulletin  88/23**

(45) Mention de la délivrance du brevet:
**30.12.92 Bulletin  92/53**

(84) Etats contractants désignés:
**DE FR GB IT NL**

(56) Documents cités:
**GB-A- 2 083 254**
**GB-A- 2 157 860**
**US-A- 3 798 615**
**US-A- 4 300 195**

**"Introduction to Series 32000 TM Architectu-re", National Semiconductor Corporation, October 1985, 3rd Edition, pages 8 et 10.**

(73) Titulaire: **THOMSON-CSF**
**51, Esplanade du Général de Gaulle**
**F-92800 Puteaux(FR)**

(72) Inventeur: **Prévost, Michel**
**THOMSON-CSF SCPI 19, avenue de Messine**
**F-75008 Paris(FR)**
Inventeur: **Vaissière, Magali**
**THOMSON-CSF SCPI 19, avenue de Messine**
**F-75008 Paris(FR)**
Inventeur: **Bergeon, Gérard**
**THOMSON-CSF SCPI 19, avenue de Messine**
**F-75008 Paris(FR)**

(74) Mandataire: **Benoit, Monique et al**
**THOMSON-CSF SCPI B.P. 329**
**F-92402 COURBEVOIE CEDEX(FR)**

## Description

La présente invention a principalement pour objet un séquenceur notamment un séquenceur d'accès direct mémoire.

Il est connu, d'utiliser dans les calculateurs des séquenceurs d'accès mémoire. Ces séquenceurs permettent de lire et/ou d'écrire dans une mémoire du calculateur sans la supervision de l'unité arithmétique et logique (UAL). Ainsi, l'utilisation des séquenceurs d'accès direct mémoire en déchargeant l'unité arithmétique et logique de certaines taches permet d'accélérer le traitement des taches assignées au calculateur.

D'autre part il est connu de réaliser des calculateurs multiprocesseurs, notamment des calculateurs à processeurs parallèles, tous les processeurs exécutant la même instruction (SIMD en terminologie anglo-saxonne), ainsi que des calculateurs comportant des processeurs parallèles indépandants (MIMD en terminologie anglo-saxonne). Le calculateur parallèle associe très souvent des mémoires privées à chaque processeur.

Un séquenceur d'accès direct mémoire de type connu ne tient par compte de spécificités des calculateurs parallèles. L'adoption d'un séquenceur direct mémoire par processeur rend difficile les communications entre processeurs et présente une coût élevé, l'utilisation d'un séquenceur d'accès direct mémoire de type connu unique pour tous les processeurs impose à tous les processeurs d'avoir le même type d'accès direct mémoire.

La séquenceur d'accès direct mémoire selon la présente invention est susceptible de gérer une pluralité de mode d'accès direct mémoire. Il est possible de passer d'un mode d'accès direct mémoire à un autre puis, instantanément de revenir au mode précédent au point où on l'a laissé. Ainsi, il est possible de gérer individuellement pour chaque processeur ou pour des groupes de processeurs, des accès directs mémoire optimisés, en tenant compte des priorités ou des interruptions gérées dans le système.

De plus, l'utilisation des multiplexeurs et des séquenceurs d'accès direct mémoire pipe-line permet l'exécution simultanée de la première adresse et son traitement par les étages pipe-lines. Ainsi, l'instruction est disponible avant d'avoir traversé tous les étages du pipe-line ce qui accèlère le fonctionnement.

L'invention concerne un séquenceur d'accès direct mémoire. Les séquenceurs d'instructions comportant une pluralité de registres ne sortent pas du cadre de la présente invention.

De tels séquenceurs permettent l'exécution, en temps partagé, de plusieurs programmes sans que dans le cas d'interruption d'un programme il soit nécessaire de recopier l'adresse de l'instruction suivante de ce programme.

On connaît d'après le document US-A-3 798 615 un calculateur comprenant des compteurs d'instructions pilotés par programme, permettant l'accès direct mémoire, mais ces compteurs ne permettent pas de gérer différents modes d'accès mémoire.

On connaît d'après la notice "Introduction to Series 32 000 TM Architecture" de National Semiconductor Corporation, Octobre 1985, 5ème édition, pages 8 et 10 l'utilisation d'un pointeur de pile de microprocesseur, mais un tel pointeur ne peut servir de séquenceur d'adressage d'une mémoire centrale, en particulier du fait qu'un séquenceur n'est pas la mémoire elle-même et que l'incrémentation du pointeur de pile connu ne permet pas de le placer à une adresse quelconque, sans rapport avec la longueur de la donnée de la pile qui va être manipulée.

L'invention a pour objet un séquenceur élémentaire d'accès direct mémoire du type destiné à générer des adresses d'écriture ou de lecture d'une mémoire centrale, lesdites adresses étant chacune fournies par un registre sélectionné dans un banc de registres comprenant une pluralité de registres au moyen d'une information de sélection de registre, ledit séquenceur comportant un compteur interposé entre l'entrée et la sortie dudit banc de registres, ledit compteur étant destiné à incrémenter ou décrémenter l'adresse mémorisée dans un desdits registres, et étant constitué de moyens de sommation de ladite adresse avec un incrément de comptage, caractérisé par le fait que ledit incrément de comptage est modifiable en valeur et en signe sur commande d'une information de choix d'incrément et que ladite valeur et ledit signe sont fournis par un bus de commande relié audit séquenceur élémentaire.

L'invention sera mieux comprise au moyen des figures annexées données comme des exemples non limitatifs parmi lesquels :

- la figure 1 est un schéma d'un séquenceur d'accès direct mémoire de type connu ;
- la figure 2 est un schéma d'un premier exemple de réalisation d'un séquenceur selon la présente invention ;
- la figure 3 est un schéma d'un deuxième exemple de réalisation d'un séquenceur selon l'invention ;
- la figure 4 est un troisième exemple de réalisation d'un séquenceur selon l'invention ;
- la figure 5 est un schéma illustrant un quatrième exemple de réalisation du dispositif selon la présente invention ;
- la figure 6 est un schéma illustrant des fonctions supplémentaires susceptibles d'être connectées au dispositif de la figure 5 ;
- la figure 7 est un schéma d'un exemple de réalisation d'un calculateur selon la présente invention.

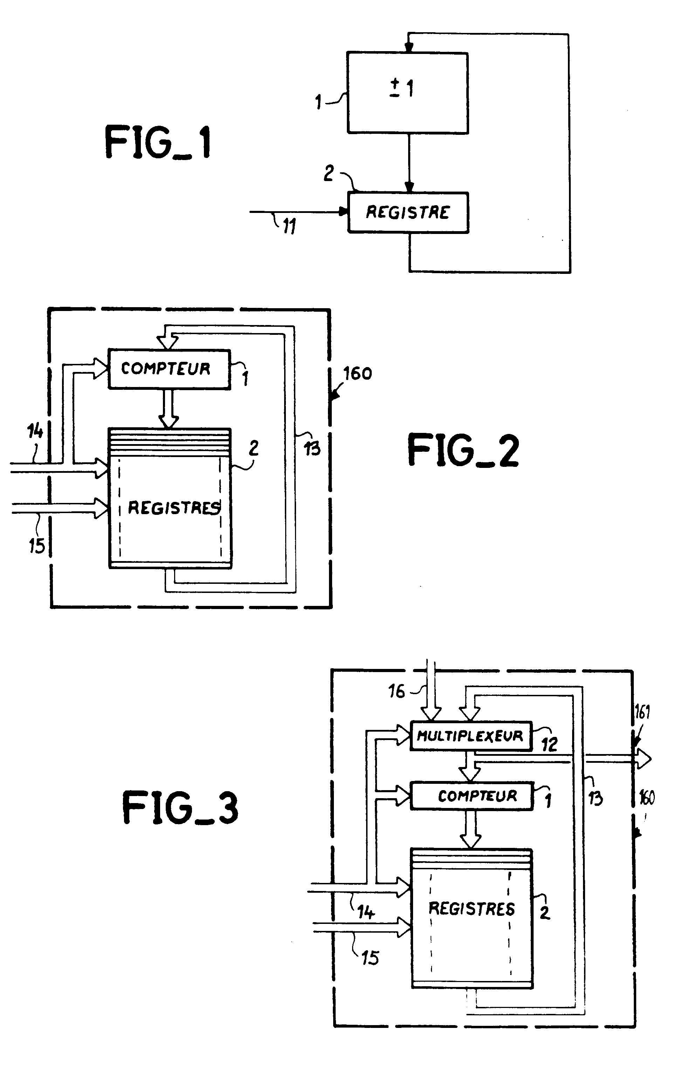

Sur les figures 1 à 7 on a utilisé les mêmes références pour désigner les mêmes éléments.

Sur la figure 1, on peut voir un exemple de séquenceur de type connu. Ce type de séquenceur peut être utilisé notamment pour la réalisation d'accès direct mémoire. Les séquenceurs de type connu comportent un dispositif de comptage ou décomptage 1 connecté à l'entrée d'un registre 2. La sortie du registre 2 est connectée à l'entrée du dispositif de comptage ou de décomptage 1. Le registre 2 est connecté à un bus de donnée 11.

Le bus de donnée 11 permet de charger dans le registre 2 une valeur correspondant à l'adresse initiale d'une lecture ou d'une écriture pour un accès direct mémoire. Le dispositif de comptage ou de décomptage 1 va, à chaque cycle d'horloge, ajouter par exemple un 1 à cette adresse initiale. Ainsi, de l'adresse initiale est déduite à chaque cycle d'horloge l'adresse des accès directs mémoire suivants. Ces adresses peuvent être lues sur un bus 11.

Sur la figure 2, on peut voir un séquenceur d'accès direct mémoire 160 selon la présente invention. Le séquenceur 160 comporte un compteur 1. La sortie du compteur 1 est reliée par un bus de donnée à un banc de registre 2. La sortie du banc de registre 2 est reliée par un bus de donnée 13 à l'entrée du compteur 1. D'autre part, le banc de registre 2 reçoit un bus de donnée 15. Le banc de registre 2, ainisi que le compteur 1 sont connectés à un bus de commande 14. Le bus de commande 14 permet de sélectionner la valeur et le signe de l'incrément du comptage du compteur 1 et un 1 des registres du banc du registre 2. Une fois un des registres du banc de registre 2 sélectionné le séquenceur d'accès direct mémoire 160 selon la présente invention fonctionne de façon analogue au séquenceur d'accès direct mémoire de la figure 1. Une adresse mémoire initiale peut être chargée dans le registre du banc de registre 2 par l'intermédiaire du bus 15. A chaque cycle d'horloge, le compteur 1 rajoute l'incrément de comptage. La somme est écrite dans le même registre du banc de registre 2. Cette somme est susceptible de servir de nouvelles adresses par lecture par l'intermédiaire du bus 15. Ainsi, le séquenceur d'accès direct mémoire 160 peut fonctionner jusqu'à la fin de l'accès direct à la mémoire, (non représenté).

Toutefois, il présente une possibilité supplémentaire. Il est possible, durant un accès direct mémoire, de traiter un second accès direct mémoire prioritaire. Pour cela le bus de commande 14 sélectionne un autre registre du banc de registre 2. Les deux registres étant parfaitement indépendants les informations contenues dans le premier registre mémoire sont conservées. Le compteur 1 rajoute soit le même, soit un nouveau incrément de comptage reçu par le bus 14 à la valeur de l'adresse contenue dans le second registre du banc de registre 2.

De même il est possible d'interrompre le second accès direct mémoire, soit pour reprendre le premier accès direct mémoire soit, en sélectionnant un troisième registre du banc de registre 2, soit de revenir au premier accès direct mémoire. Le passage d'un registre à un autre est instantané. Le nombre d'accès direct mémoire, différents à un instant donné, n'est limité que par le nombre de registres disponibles dans le banc de registre 2.

Dans un premier exemple de réalisation du séquenceur d'accès direct mémoire 160, le banc de registre 2 comporte 16 registres.

Dans un second exemple de réalisation du séquenceur d'accès direct mémoire 160 le banc de registre 2 comporte 128 registres.

L'utilisation d'un banc de registre 2 comportant une pluralité de registres permet d'effectuer simultanément, ou alternativement des accès directs mémoire pour une pluralité de processeurs.

Avantageusement, l'utilisation d'un banc de registre 2 permet d'avoir plusieurs modes différents d'accès direct mémoire. Par exemple il est possible d'accéder à un tableau selon les lignes, selon les colonnes, de lire ou de n'écrire que dans une mémoire sur deux, ou d'opérer des accès directs mémoire simultanément sur plusieurs tableaux. La commutation instantanée entre les divers modes d'accès direct mémoire permet d'avoir une grande souplesse d'utilisation. Elle permet par exemple de répartir un flot de données entre une pluralité de processeurs de calcul.

Sur la figure 3, on peut voir un séquenceur d'accès direct mémoire 160 comportant un multiplexeur 12. La sortie du multiplexeur 12 est connectée à l'entrée du compteur 1. La sortie du compteur 1 est connectée aux entrées due banc registre 2. La sortie du banc de registre 2 est connectée à l'une des entrées du mutliplexeur 12 par l'intermédiaire du bus 13. Un bus de donnée 16 est connecté à une seconde entrée du multiplexeur 12. Le bus de donnée 15 est connecté au banc de registre 2. Le bus de commande 14 est connecté au registre 2, au compteur 1, et au multiplexeur 12. Les ordres véhiculés par le bus 14 permettent de sélectionner un registre du banc de registre 2, de choisir l'incrément de comptage du compteur 1 et de connecter soit le bus 13, soit le bus 16 à la sortie du multiplexeur 12.

Le multiplexeur 12 permet de rajouter par l'intermédiaire du bus 16 une valeur de la boucle de comptage des adresses des accès directs mémoire.

Les résultats calculés par le séquenceur 160 sont accessibles soit par le bus 15 soit par un bus 161 connecté à la sortie du multiplexeur 12.

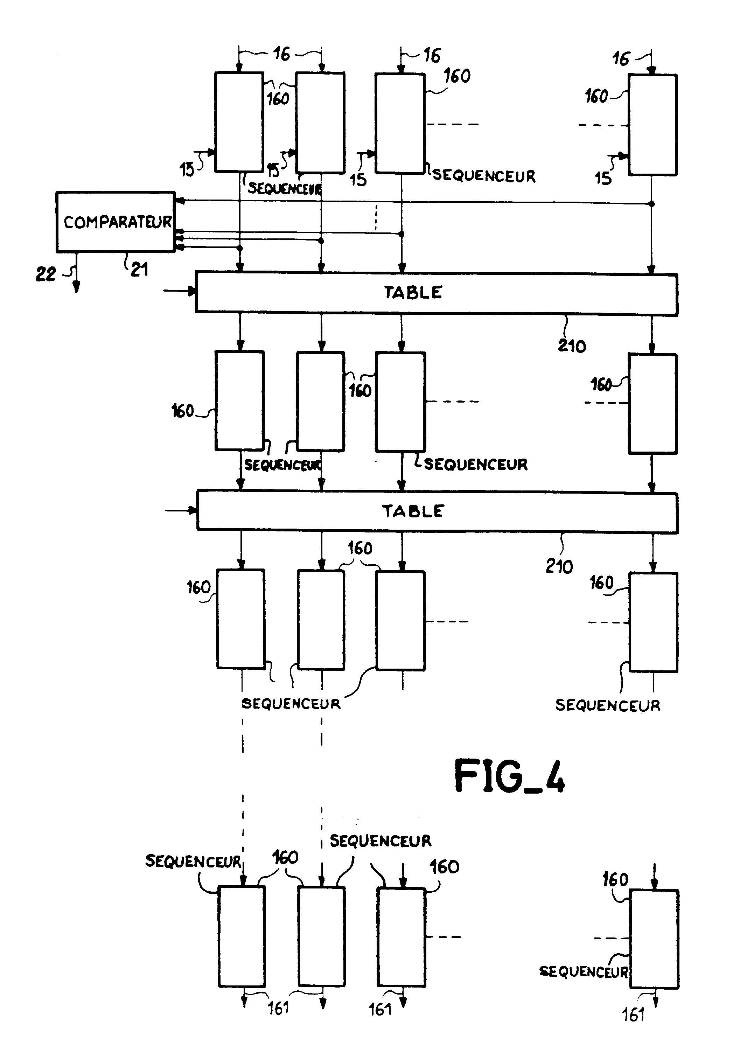

Sur la figure 4, on peut voir un exemple de réalisation d'un séquenceur comportant plusieurs étages pipe-lines. Chaque étage pipe-line du séquenceur selon l'invention comporte une pluralité de séquenceurs élémentaires analogue au séquenceur d'accès direct mémoire 160 des figures 2 et/ou 3. Chaque séquenceur élémentaire 160 traite une partie de l'adresse de l'accès direct mémoire. Par exemple, pour un étage pipe-line donné, chaque séquenceur élémentaire 160 traite une partie d'une adresse à l'intérieur d'un tableau multidimensionnel.

Les séquenceurs élémentaires 160 reçoivent par le bus de donnée 16 et/ou 15 les données à traiter.

Avantageusement, les sorties des séquenceurs d'accès direct mémoire élémentaire 160 sont reliées à un comparateur 21. Le comparateur 21 est susceptible de délivrer un signal 22 de déplacement des tableaux, de changement de mode ou toute autre opération conditionnée par un état de la machine. D'autre part, les sorties des séquenceurs élémentaires d'accès direct mémoire 160 sont reliées à un dispositif de transcodage 210. Le dispositif de transcodage 210 est par exemple une mémoire morte (ROM en terminologie anglo-saxonne) dans lequel ont été tabulées les valeurs du transcodage.

Dans une variante de réalisation du dispositif selon l'invention, le dispositif de transcodage 210 est une logique câblée. Les sorties du dispositif de transcodage 210 sont reliées aux entrées d'une pluralité de séquenceurs élémentaires d'accès direct mémoire 160 de l'étage pipe-line suivant.

Les sorties du second étage sont connectées d'une part aux entrées d'un comparateur 21 (non représenté) et d'autre part à un dispositif de transcodage 210.

Les sorties du dispositif de transcodage 210 sont reliés aux entrées des séquenceurs élémentaires d'accès direct mémoire 160 de l'étage pipe-line suivant. Et ainsi de suite jusqu'au séquenceur d'accès direct mémoire 160 du dernier étage pipe-line à la sortie duquel sont disponibles les adresses de lecture ou d'écriture en mémoire.

L'utilisation d'un séquenceur d'accès direct mémoire pipe-line permet un calcul de grande rapidité avec une très bonne résolution. Chaque étage pipe-line fournit une adresse mémoire plus précise que l'étage précédent. Par exemple un dispositif à trois étages pipe-line permet au premier étage de sélectionner le boîtier mémoire vive au second étage de sélectionner les tableaux à l'intérieur de chaque boîtier, le troisième étage sélectionnant l'adresse à l'intérieur du tableau.

Il est bien entendu qu'un séquenceur d'accès direct mémoire comportant un seul étage de séquenceur élémentaire d'acccès direct mémoire 160 permettant l'accès à des tableaux multidimensionnels ne sort pas du cadre de la présente invention.

De même, l'utilisation d'un séquenceur d'accès direct mémoire comportant une pluralité d'étages pipe-line composé d'un unique séquenceur élémentaire d'accès direct mémoire 160 ne sort pas du cadre de la présente invention.

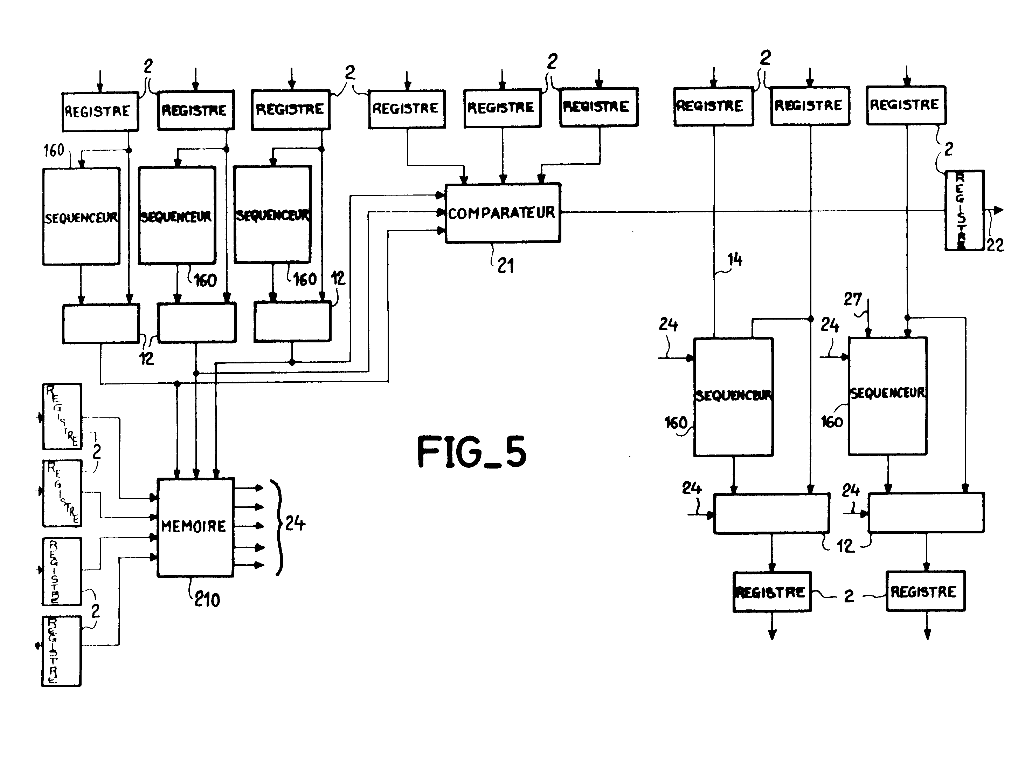

Sur la figure 5, on peut voir un exemple de réalisation de séquenceur d'accès direct mémoire selon l'invention. Le séquenceur de la figure 5 comporte un premier étage de trois séquenceurs d'accès direct mémoire 160 reliés par l'intermédiaire d'un dispositif de transcodage 210 à un second étage comportant deux séquenceurs élémentaires d'accès direct mémoire 160.

Avantageusement, les trois séquenceurs élémentaires d'accès direct mémoire 160 sont analogues aux séquenceurs élémentaires d'accès direct mémoire 160 de la figure 3. La sortie de chaque séquenceur d'accès direct mémoire 160 est reliée à une première entrée d'un multiplexeur 12. L'entrée de chaque séquenceur élémentaire d'accès direct mémoire 160 est reliée à l'autre entrée du multiplexeur 12. Ainsi, il est possible de traiter simultanément à l'intérieur des séquenceurs élémentaires d'accès direct mémoire 160, une donnée qui est déjà disponible à leurs sorties. Lors du démarrage des calculs on ne perd pas un seul cycle d'horloge.

La sortie des trois multiplexeurs 12 est reliée d'une part à un dispositif de décodage 210 et d'autre part à un comparateur 21.

Le dispositif de décodage 210 comporte trois entrées provenant de l'extérieur du séquenceur direct mémoire, une pluralité de sorties 24 interne aux séquenceurs d'accès direct mémoire et une sortie externe aux séquenceurs d'accès direct mémoire.

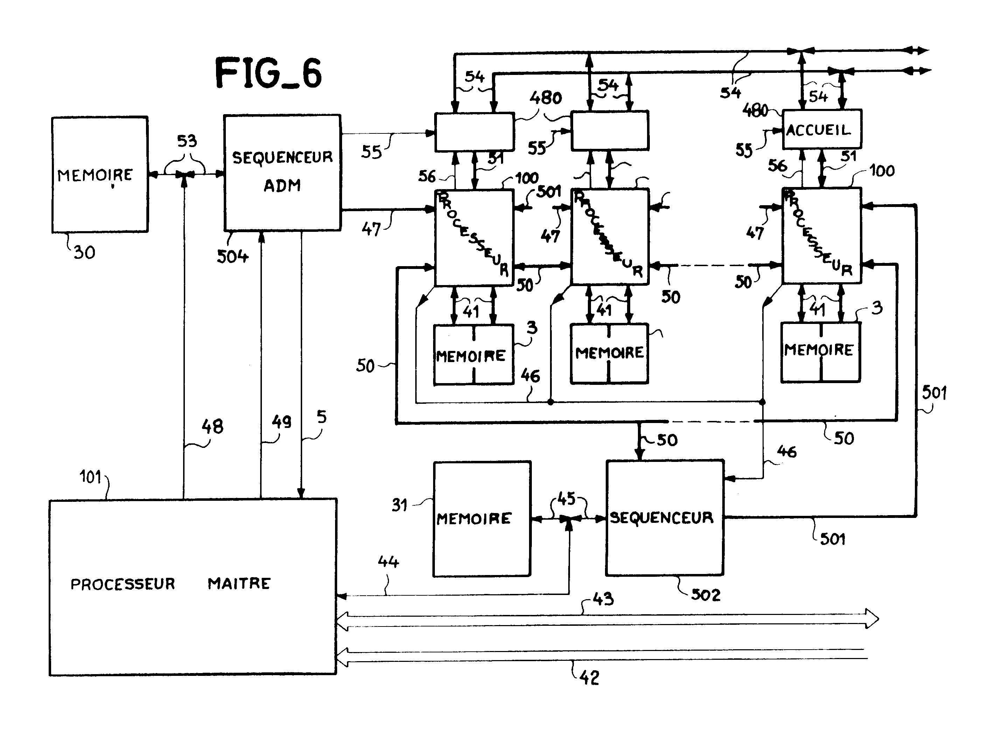

Le comparateur 21 reçoit sur trois lignes la valeur maximale des tableaux qu'il doit pouvoir comparer aux valeurs actuellement atteintes provenant du multiplexeur 12. Le comparateur 21 émet un signal 22 quand la valeur maximale d'un tableau a été atteinte. Le second étage pipe-line du séquenceur d'accès direct mémoire comporte deux séquenceurs élémentaires d'accès direct mémoire 160 recevant d'une part des données par une ligne extérieure et d'autre part des commandes 24 provenant du dispositif de transcodage 210. D'autre part, un des séquenceurs élémentaires d'accès direct mémoire 160 reçoit la commande de mode d'adressage 27 à partir d'un décodeur illustré sur la figure 6. La sortie des séquenceurs élémentaires d'accès direct mémoire est reliée à une première entrée du multiplexeur 12. La seconde entrée du multiplexeur 12 est reliée aux entrées dudit séquenceur élémentaire d'accès direct mémoire 160.

Le multiplexeur 12 associé au multiplexeur interne au séquenceur élémentaire d'accès direct mémoire 160 permet lors de l'initialisation des calculs de disposer directement en sortie de la première adresse.

Avantageusement, le dispositif selon la présente invention comporte, sur ses entrées et ses sorties, des registres 2 permettant une bonne synchronisation des signaux.

Avantageusement, le séquenceur d'accès direct mémoire selon la présente invention comporte une pile premier entré premier sorti (FIFO en terminologie anglo-saxonne) permettant d'anticiper le calcul d'adresse des accès direct mémoire.

Sur la figure 6, on peut voir un exemple de réalisation d'un calculateur parallèle (SIMD) comportant un séquenceur d'accès direct mémoire selon l'invention. Le calculateur comporte N processeurs 100. Les processeurs 100 sont par exemple des processeurs numériques de grande puissance nécessaires au traitement du signal.

Les processeurs 100 son connectées à une mémoire de données 3.

Avantageusement, chaque processeur 100 est relié par un bus 41 à un banc de mémoire privée 3.

Avantageusement, chaque processeur 100 est relié par deux bus 41 à une mémoire 3 partagée en deux bancs mémoire.

Avantageusement, les processeurs 100 sont susceptibles de communiquer entre eux par un bus 50.

Avantageusement, le bus 50 est un bus en anneaux.

Avantageusement, les calculateurs selon l'invention comportent un séquenceur 502 fournissant par un bus 501 les instructions nécessaires au fonctionnement des processeurs 100. Le séquenceur 502 est relié à une mémoire de programme 31 par un bus 45.

Avantageusement, les données susceptibles d'être traitées par le processeur 100 sont chargées dans le banc de mémoire 3 durant l'exécution de calcul par le processeur 100. Le chargement des mémoires 3 en ce qui concerne les données transitant par le bus 51 est supervisé par un séquenceur d'accès direct mémoire 504 selon l'invention. Le séquenceur accès direct mémoire est relié à une mémoire programme 30 par l'intermédiaire d'un bus 53.

Dans une première variante de réalisation du dispositif selon l'invention, les bancs de mémoire 3 disposent d'un bus de donnée réservé à l'accès direct mémoire.

Avantageusement, les échanges avec les bancs de mémoire sont effectués au travers des processeurs 100 par le bus 41. Cette solution présente l'avantage de simplifier la connectique du calculateur.

Avantageusement, le séquenceur accès direct mémoire 504 est relié par un bus 47 au processeur 100. Le bus 47 permet au séquenceur accès direct mémoire 504 de sélectionner le mode d'accès direct mis en oeuvre et les adresses des mémoires 3 en ce qui concerne les données transmises par le bus 51.

Avantageusement, les processeurs 100 reçoivent une pluralité de bus 54 à large bande les données à stocker en mémoire 3. L'utilisation d'une pluralité de bus permet d'augmenter les débits des données transmises.

Avantageusement, les calculateurs selon la présente invention comportent des circuits d'accueil 480 permettant de transmettre sur un bus unique d'entrée-sortie 51 au processeur 100 les données arrivant sur une pluralité de bus 54, Le bus 51 étant de faible longueur sa bande passante est par exemple égale à la somme de bande passante totale des bus 54. Dans une variante de réalisation sa bande passant est inférieure.

Avantageusement, les circuits d'accueil 480 permettent d'autre part, de faire l'adaptation électrique des bus 54 ce qui permet d'augmenter le débit desdits bus.

Avantageusement, les circuits d'accueil 480 permettent, par exemple en utilisant une électronique trois états, d'isoler le processeur 100 des bus 54. Cette isolation électrique permettra tous les circuits d'accueil 480, sauf un, étant en haute impédance, au processeur 100 dont le circuit d'accueil est en basse impédance d'émettre des données sur le bus 54. Les circuits d'accueil 480 reçoivent en partie les commandes de fonctionnement à partir du séquenceur d'accès direct mémoire 504 par l'intermédiaire d'un bus 55. L'autre partie des commandes provient directement du processeur 100 associé par le chemin 56.

Avantageusement, le calculateur selon l'invention comporte un processeur maître 101 supervisant le bon fonctionnement du calculateur. Le processeur maître 101 est par exemple un processeur d'usage général.

Dans un exemple de réalisation du dispositif selon la présente invention le processeur maître 101 appartient à la famille des microprocesseurs d'usage général 68000 commercialisée par la Société MOTOROLA. Par exemple, le processeur maître 101 est un microprocesseur 68020 commercialisé par la Société MOTOROLA. On peut remarquer, que la puissance de calcul du processeur maître 101 est de plusieurs ordres inférieure à celle du processeur 100. Toutefois, cette puissance de calcul est suffisante pour superviser le bon fonctionnement du calculateur selon l'invention. Le processeur maître 101 est relié par un bus 42 au dispositif de commande, par exemple à un calculateur frontal, duquel il reçoit les ordres des calculs à exécuter. Le processeur maître 101 est relié d'autre part, par un bus 43 à des dispositifs de traitement amont. Par dispositif de traitement amont on désigne les dispositifs de prétraitement analogique et/ou numérique du signal comme par exemple des échantillonneurs, des calculateurs de transformée de Fourier rapide, les dispositifs aval étant susceptibles d'utiliser les calculs réalisés par le calculateur selon l'invention. Les dispositifs aval sont par exemple des calculateurs d'usage général. D'autre part, le processeur maître 101 est relié par un bus de donnée 48 et le bus 53 à la mémoire 30.

Le processeur maître 101 est relié par un bus 44 et le bus 45 à la mémoire 31. Le processeur maître peut ainsi charger les programmes nécessaires au fonctionnement du calculateur les mémoires 30 et 31 reliées respectivement au séquenceur d'accès direct mémoire 504 et au séquenceur 502. Ces programmes sont chargés à partir des mémoires de masse, par exemple disque magnétique ou bande magnétique, non représentés sur la figure 6.

D'autre part, le processeur maître 101 est relié par un bus de commande 49 au séquenceur d'accès direct mémoire 504.

Avantageusement, le séquenceur d'accès direct mémoire 504 va répartir le flot de données à traiter arrivant des dispositifs de traitement amont par le bus 54 entre les divers processeurs 100 en fonctionnement. Simultanément, le séquenceur 502 va numéroter les processeurs 100 en leur assignant une tâche. Dans la mesure où tous les processeurs 100 reçoivent par l'intermédiaire du bus 501 la même commande ils exécutent simultanément le même traitement. Toutefois, chaque processeur 100 comporte un bus de commande 56 le reliant au circuit d'accueil 480. Ainsi, chaque processeur 100 peut agir sur son circuit d'accueil 480 d'une façon qui est déterminée par le résultat de calculs qu'il effectue.

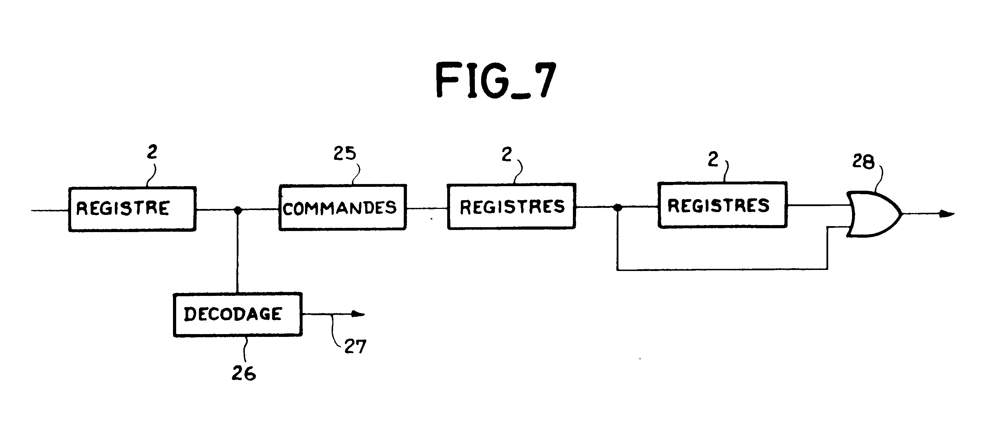

Sur la figure 7, on peut voir un dispositif de commande des circuits d'accueil 480. Le dispositif de la figure 7 comporte un dispositif de décodage 26 placé en parallèle avec un dispositif de commande 25. La sortie du dispositif de commande 25 est reliée à deux piles de registres 2. La sortie de la première pile est reliée à l'entrée de la seconde pile et à une première entrée d'une porte logique OU. La sortie d'une seconde pile de registres est reliée à la seconde entrée de la porte logique OU 28. Les piles de registres permettent d'obtenir les synchronisation désirées.

L'invention s'applique principalement à la réalisation des calcuateurs.

L'invention s'applique notamment à la réalisation de calculateurs comportant une pluralité de processeurs travaillant en parallèle.

## Revendications

1. Séquenceur élémentaire (160) d'accès direct mémoire du type destiné à générer des adresses d'écriture ou de lecture d'une mémoire centrale, lesdites adresses étant chacune fournies par un registre sélectionné dans un banc de registres (2) comprenant une pluralité de registres au moyen d'une information de sélection de registre, ledit séquenceur comportant un compteur (1) interposé entre l'entrée et la sortie dudit banc de registres, ledit compteur étant destiné à incrémenter ou décrémenter l'adresse mémorisée dans un desdits registres, et étant constitué de moyens (2, 13) de sommation de ladite adresse avec un incrément de comptage, caractérisé par le fait que ledit incrément de comptage est modifiable en valeur et en signe sur commande d'une information de choix d'incrément et que ladite valeur et ledit signe sont fournis par un bus de commande (14) relié audit séquenceur élémentaire (160).

2. Séquenceur élémentaire selon la revendication 1, caractérisé en ce que ladite information de sélection de registre est fournie par un bus de commande (14) coopérant avec ledit séquenceur élémentaire (160).

3. Séquenceur élémentaire selon l'une des revendications 1 ou 2, caractérisé en ce que les moyens de sommation comportent un compteur (1) dont l'entrée est reliée par un premier bus de données (13) à la sortie du banc de registres (2), et dont la sortie est reliée par un deuxième bus à ce banc de registres.

4. Séquenceur élémentaire selon l'une quelconque des revendications 1 à 3, caractérisé en ce qu'il comporte un multiplexeur (12) dont l'une des entrées est connectée à la sortie desdits registres (2) dudit séquenceur élémentaire (160), la seconde entrée étant connectée à un bus de données (16), et la sortie à l'entrée dudit compteur (1) dudit séquenceur élémentaire (160).

5. Séquenceur, caractérisé en ce qu'il comporte une pluralité de séquenceurs élémentaires (160) selon l'une quelconque des revendications 1 à 4.

6. Séquenceur selon la revendication 5, caractérisé en ce que lesdits séquenceurs élémentaires (160) sont montés en parallèle de façon à pouvoir calculer des adresses mémoire en parallèle.

7. Séquenceur selon la revendication 5, caractérisé en ce que lesdits séquenceurs élémentaires (160) sont connectés en série.

8. Séquenceur selon l'une quelconque des revendications 6 et 7, caractérisé en ce que les sorties desdits séquenceurs élémentaires (160) sont raccordées à un comparateur (21).

9. Séquenceur selon l'une quelconque des revendications 6 à 8, caractérisé en ce qu'il comporte un dispositif de transcodage (210) raccordé auxdits séquenceurs élémentaires (160).

10. Séquenceur selon a revendication 9, caractérisé en ce que ledit dispositif de transcodage (210) est constitué par une mémoire morte (ROM).

11. Calculateur, caractérisé en ce qu'il comprend au moins un séquenceur selon l'une quelconque des revendications 1 à 10.

12. Calculateur selon la revendication 11, caractérisé en ce qu'il comporte une pluralité de processeurs (100) susceptibles d'effectuer des traitements en parallèle.

## Claims

1. An elementary sequencer (160) with direct memory access of the type intended to generate write or read addresses in a central memory, said addresses each being supplied by a register selected from a bank of registers (2) comprising a plurality of registers by means of register selection data, said sequencer comprising a counter (1) interposed between the input and the output of said bank of registers, said counter being intended to increment or decrement the address stored in said registers, and being constituted by means (2,13) for the summing of said address with a counting increment, characterised by the fact that said counting increment can be modified as to value and sign when commanded by increment choice data and that said value and said sign are supplied by a control bus (14) connected to said elementary sequencer (160).

2. An elementary sequencer according to Claim 1, characterised in that said register selection data is supplied by a control bus (14) cooperating with said elementary sequencer (160).

3. An elementary sequencer according to one of Claims 1 or 2, characterised in that the summing means comprise a counter (1), the input of which is connected by a first data bus (13) to the output of the bank of registers (2), and the output of which is connected by a second bus to this bank of registers.

4. An elementary sequencer according to any one of Claims 1 to 3, characterised in that it comprises a multiplexer (12), one of the inputs of which is connected to the output of said registers (2) of said elementary sequencer (160), the second input being connected to a data bus (16), and the output to the input of said counter (1) of said elementary sequencer (160).

5. A sequencer, characterised in that it comprises a plurality of elementary sequencers (160) according to any one of Claims 1 to 4.

6. A sequencer according to Claim 5, characterised in that said elementary sequencers (160) are mounted in parallel so as to be able to calculate memory addresses in parallel.

7. A sequencer according to Claim 5, characterised in that said elementary sequencers (160) are connected in series.

8. A sequencer according to any one of Claims 6 and 7, characterised in that the outputs of said elementary sequencers (160) are connected to a comparator (21).

9. A sequencer according to any one of Claims 6 to 8, characterised in that it comprises a code conversion device (210) connected to said elementary sequencers (160).

10. A sequencer according to Claim 9, characterised in that said code conversion device (210) is constituted by a read-only memory (ROM).

11. A computer, characterised in that it comprises at least one sequencer according to any one of Claims 1 to 10.

12. A computer according to Claim 11, characterised in that it comprises a plurality of processors (100) capable of carrying out processing in parallel.

## Patentansprüche

1. Elementarfolgeschaltung (160) zum direkten Speicherzugriff, die dazu bestimmt ist, Schreib- oder Leseadressen für eine zentralen Speicher zu erzeugen, wobei diese Adressen je von einem in einer mehrere Register enthaltenden Registerbank (2) aufgrund einer Registerauswahlinformation ausgewählten Register geliefert werden und wobei die Folgeschaltung einen Zähler aufweist, der zwischen den Eingang und den Ausgang der Registerbank eingefügt ist und die in diesen Registern gespeicherte Adresse inkrementieren oder dekrementieren soll mithilfe von Mitteln (2, 13) zum Summieren dieser Adresse mit einem Zählinkrement, dadurch gekennzeichnet, daß das Zählinkrement nach Wert und Vorzeichen durch Steuerung aufgrund einer Inkrementwahlinformation verändert werden kann und daß dieser Wert und dieses Vorzeichen von einem Steuerbus (14) geliefert werden, der an die Elementarfolgeschaltung (160) angeschlossen ist.

2.    Elementarfolgeschaltung nach Anspruch 1, dadurch gekennzeichnet, daß die Registerauswahlinformation von einem Steuerbus (14) geliefert wird, der mit der Elementarfolgeschaltung (160) zusammenwirkt.

3.    Elementarfolgeschaltung nach einem der Ansprüche 1 und 2, dadurch gekennzeichnet, daß die Summiermittel einen Zähler (1) aufweisen, dessen Eingang über einen ersten Datenbus (13) an den Ausgang der Registerbank (2) und dessen Ausgang über eine zweiten Bus an diese Registerbank angeschlossen ist.

4.    Elementarfolgeschaltung nach einem beliebigen der Ansprüche 1 bis 3, dadurch gekennzeichnet, daß sie einen Multiplexer (12) enthält, der mit einem Eingang an den Ausgang der Register (2) der Elementarfolgeschaltung (160) und mit einem zweiten Eingang an einen Datenbus (16) angeschlossen ist, während der Ausgang an den Eingang des Zählers (1) der Elementarfolgeschaltung (160) angeschlossen ist.

5.    Folgeschaltung, dadurch gekennzeichnet, daß sie eine Mehrzahl von Elementarfolgeschaltungen (160) gemäß einem beliebigen der Ansprüche 1 bis 4 enthält.

6.    Folgeschaltung nach Anspruch 5, dadurch gekennzeichnet, daß die Elementarfolgeschaltungen (160) parallelgeschaltet sind, so daß sie parallel Speicheradressen berechnen können.

7.    Folgeschaltung nach Anspruch 5, dadurch gekennzeichnet, daß die Elementarfolgeschaltungen (160) in Reihe geschaltet sind.

8.    Folgeschaltung nach einem beliebigen der Ansprüche 6 und 7, dadurch gekennzeichnet, daß die Ausgänge der Elementarfolgeschaltungen (160) an eine Komparator (21) angeschlossen sind.

9.    Folgeschaltung nach einem beliebigen der Ansprüche 6 bis 8, dadurch gekennzeichnet, daß sie eine Transkodiervorrichtung (210) enthält, die an die Elementarfolgeschaltungen (160) angeschlossen ist.

10.   Folgeschaltung nach Anspruch 9, dadurch gekennzeichnet, daß die Transkodiervorrichtung (210) aus einem Festwertspeicher (ROM) besteht.

11.   Rechner, dadurch gekennzeichnet, daß er mindestens eine Folgeschaltung nach einem beliebigen der Ansprüche 1 bis 10 enthält.

12.   Rechner nach Anspruch 11, dadurch gekennzeichnet, daß er eine Mehrzahl von Prozessoren (100) enthält, die Verarbeitungen parallel durchführen können.

EP 0 270 402 B1

FIG_1

1   ± 1

2   REGISTRE

11

FIG_2

COMPTEUR 1

160

14

REGISTRES 2

13

15

FIG_3

16

MULTIPLEXEUR 12

161

COMPTEUR 1

13

160

14

REGISTRES 2

15

9

FIG_4

FIG_5

# FIG_6

MEMOIRE 30

SEQUENCEUR ADM 504

53

MEMOIRE 31

SEQUENCEUR 502

45

44

43

42

PROCESSEUR MAITRE 101

48 49 5

55 56

480 54 54

ACCUEIL

54 54

480

55 56 51

PROCESSEUR 100

PROCESSEUR

PROCESSEUR 100

501 47

47 501

47

50 50 50

41 41 41

MEMOIRE 3

MEMOIRE 3

MEMOIRE 3

46

50

50 46

501

50

501

EP 0 270 402 B1

# FIG_7